# EUROPEAN PATENT APPLICATION

(11) **EP 4 181 197 A1**
(43) Date of publication of application: **17.05.2023**
(21) Application number: 21883019.8
(22) Date of filing: 14.09.2021
(51) Int. Cl.: H01L 25/075, H01L 27/12, H01L 25/16

(54) **DISPLAY MODULE AND METHOD FOR MANUFACTURING SAME**

(30) Priority: 23.10.2020 KR 20200138488
(71) Applicant: Samsung Electronics Co., Ltd., Suwon-si, Gyeonggi-do 16677 (KR); Research Business Foundation Sungkyunkwan University, Suwon-si, Gyeonggi-do 16419 (KR)
(72) Inventor: OH, Donggun, Suwon-si Gyeonggi-do 16677 (KR); KIM, Yong-Sang, Suwon-si Gyeonggi-do 16419 (KR); KIM, Jinho, Suwon-si Gyeonggi-do 16677 (KR)
(74) Representative: Appleyard Lees IP LLP
(86) International application number: PCT/KR2021/012473
(87) International publication number: WO 2022/085947

(57) **Abstract**

Disclosed is a display module. The disclosed display module comprises: a glass substrate; a thin film transistor (TFT) layer formed on the front surface of the glass substrate and having a plurality of TFT electrodes; a plurality of light emitting diodes electrically connected to the plurality of TFT electrodes; and a plurality of through-wiring members arranged at intervals along an edge region of the glass substrate and electrically connected to wiring formed on the front surface and rear surface of the glass substrate. Each of the plurality of through-wiring members includes: a first conductive member formed on the front surface of the glass substrate; a second conductive member formed on the rear surface of the glass substrate; and a third conductive member that passes through the glass substrate and is stacked on the first and second conductive members.

## Description

### [TECHNICAL FIELD]

The disclosure relates to a display module and a method for manufacturing the same, and more particularly, to a display module that may achieve a bezel-less feature and a method for manufacturing the same.

### CROSS-REFERENCE TO RELATED APPLICATIONS

This application is based on and claims priority to Korean Patent Application No. 10-2020-0138488, filed on October 23, 2020, in the Korean Intellectual Property Office, the disclosure of which is incorporated by reference herein in its entirety.

### [BACKGROUND ART]

A self-luminous display element displays an image without a backlight unit, and a micro light emitting diode (LED) that emits light by itself may be used.

A display module is operated in units of pixels or sub-pixels including micro LEDs to express various colors. Operation of each pixel or sub-pixel is controlled by a plurality of thin film transistors (TFTs). The plurality of TFTs are arranged on a flexible substrate, a glass substrate, or a plastic substrate, and such a substrate is called a TFT substrate. A large display device is manufactured by connecting a plurality of display modules.

### [DISCLOSURE]

### [TECHNICAL PROBLEM]

An object of the disclosure is to provide a display module in which a wiring connecting a front surface and a rear surface of a TFT substrate is formed by drilling a through hole, and a method for manufacturing the same.

The disclosure for achieving the object provides a display module including: a glass substrate; a thin film transistor (TFT) layer formed on a front surface of the glass substrate and including a plurality of TFT electrodes; a plurality of light emitting diodes electrically connected to the plurality of TFT electrodes; and a plurality of through wiring members disposed at intervals along an edge area of the glass substrate and electrically connected to wirings formed on the front surface and a rear surface of the glass substrate, respectively, in which each of the plurality of through wiring members includes: a first conductive member formed on the front surface of the glass substrate; a second conductive member formed on the rear surface of the glass substrate; and a third conductive member penetrating through the glass substrate and having both ends stacked on the first conductive member and the second conductive member, respectively.

The third conductive member may include: a first pad portion stacked on the first conductive member and exposed to the outside; a second pad portion stacked on the second conductive member and exposed to the outside; and a connection portion electrically connected to the first pad and the second pad and disposed in a through hole of the glass substrate.

The first pad portion may be electrically connected to a first wiring formed on the front surface of the glass substrate, and the second pad portion may be electrically connected to a second wiring formed on the rear surface of the glass substrate.

The first pad portion may have one side in contact with a corner where the front surface and a side surface of the glass substrate meet each other, and the second pad portion may have one side in contact with a corner where the rear surface and the side surface of the glass substrate meet each other.

The first pad portion may have one side spaced apart from a corner where the front surface and a side surface of the glass substrate meet each other, and the second pad portion may have one side spaced apart from a corner where the rear surface and the side surface of the glass substrate meet each other

The first pad portion may cover the entire first conductive member, and the second pad portion may cover the entire second conductive member.

A width of the first pad portion and a width of the second pad portion may be larger than a width of a wiring connected to each of the first pad portion and the second pad portion.

Further, the disclosure may achieve the object by providing a method for manufacturing a display module, the method including: forming a plurality of first and second conductive members at regular intervals in an edge area of a glass substrate having a front surface on which a thin film transistor (TFT) layer is formed; forming a plurality of through holes each penetrating through the glass substrate at positions corresponding to the plurality of first and second conductive members; forming a third conductive member having one end stacked on the first conductive member to be electrically connected to the first conductive member and the other end stacked on the second conductive member to be electrically connected to the second conductive member through each through hole; forming a first wiring electrically connected to one end of each third conductive member on the front surface of the glass substrate and a second wiring electrically connected to the other end of each third conductive member on a rear surface of the glass substrate; and transferring a plurality of micro LEDs to the TFT layer, in which one first conductive member, one second conductive member corresponding to the first conductive member, and one third conductive member electrically connected to the first conductive member and the second conductive member form one through wiring member.

The method may further include, before the forming of the third conductive member, stacking a first photoresist layer to cover the front surface of the glass substrate including the TFT layer except for the plurality of first conductive members, and stacking a second photoresist layer to cover the rear surface of the glass substrate except for the plurality of second conductive members.

The forming of the third conductive member may further include covering the plurality of first and second conductive members and the first and second photoresist layers with a conductive material.

The conductive material may be formed by a plating method in such a way that the conductive material is partially introduced into the plurality of through holes.

The first photoresist layer may be formed to have a thickness larger than that of the first conductive member, and the second photoresist layer may be formed to have a thickness larger than that of the second conductive member.

The method may further include removing a part of a metal material until upper surfaces of the first and second photoresist layers covered with the metal material are exposed.

The method may further include, after the removing of the part of the metal material, removing the first and second photoresist layers. The part of the metal material may be removed to a predetermined height by a planarization process.

### [BRIEF DESCRIPTION OF DRAWINGS]

FIG. 1 is a plan view schematically illustrating a display module according to an embodiment of the disclosure.
FIG. 2 is a cross-sectional view schematically illustrating the display module according to an embodiment of the disclosure.
FIG. 3 is a view illustrating an example in which a wiring is electrically connected to a through wiring member formed at an edge portion of a thin film transistor (TFT) substrate.
FIG. 4 is a flowchart illustrating a process of manufacturing the display module according to an embodiment of the disclosure.
FIG. 5A is a view illustrating an example in which a first conductive member is formed on the edge portion of the TFT substrate.
FIG. 5B is a cross-sectional view taken along line A-A in FIG. 5A.
FIG. 6A is a diagram illustrating an example in which photoresist layers are formed in areas other than areas where first and second conductive members are formed, in an entire area of each of a front surface and a rear surface of the TFT substrate.
FIG. 6B is a cross-sectional view taken along line B-B in FIG. 6A.
FIG. 7A is a view illustrating an example in which a through hole is formed in the TFT substrate.
FIG. 7B is a cross-sectional view taken along line C-C in FIG. 7A.
FIG. 8A is a view illustrating an example in which a third conductive member is formed on the front and rear surfaces of the TFT substrate while filling the through hole formed in the TFT substrate.
FIG. 8B is a cross-sectional view taken along line D-D in FIG. 8A.
FIG. 9A is a view illustrating an example in which an upper portion of the third conductive member is polished up to an upper surface of the photoresist layer.
FIG. 9B is a cross-sectional view taken along line E-E in FIG. 9A.
FIG. 10A is a view illustrating an example in which the photoresist layers are removed from the front and rear surfaces of the TFT substrate.
FIG. 10B is a cross-sectional view taken along line F-F in FIG. 10A.
FIG. 11 is a view illustrating an example of overcoming a position error of the wiring according to a length of a first pad portion of the through wiring member in an X direction.
FIG. 12 is a view illustrating an example in which the first conductive member formed at the edge portion of the TFT substrate is spaced apart from one end of the TFT substrate by a predetermined distance M in a Y direction.
FIG. 13 is a view illustrating an example in which the through wiring member is formed using the TFT substrate illustrated in FIG. 12.

### [MODE FOR CARRYING OUT THE INVENTION]

Hereinafter, various embodiments will be described in more detail with reference to the accompanying drawings. Embodiments mentioned in the specification may be variously modified. A specific embodiment may be illustrated in the drawings and be described in detail in the detailed description. However, the specific embodiment illustrated in the accompanying drawings is provided only to allow various embodiments to be easily understood. Therefore, it should be understood that the disclosure is not limited by the specific embodiment illustrated in the accompanying drawings, and includes all the modifications, equivalents, and substitutions included in the spirit and the scope of the disclosure.

Terms including ordinal numbers such as "first", "second", and the like, may be used to describe various components. However, these components are not limited by these terms. These terms are used only to distinguish one component from another component.

It should be further understood that terms "include" or "have" used in the specification indicates the presence of features, numerals, steps, operations, components, parts mentioned in the specification, or combinations thereof, but does not preclude the presence or addition of one or more other features, numerals, steps, operations, components, parts, or combinations thereof. It is to be understood that when one component is referred to as being "connected to" or "coupled to" another component, one component may be connected directly to or coupled directly to another component or be connected to or coupled to another component with the other component interposed therebetween. On the other hand, it is to be understood that when one component is referred to as being "connected directly to" or "coupled directly to" another component, it may be connected to or coupled to another component without the other component interposed therebetween.

In the disclosure, the expression "the same" not only includes complete sameness but also a difference in consideration of a matching error range.

Further, in describing the disclosure, when it is determined that a detailed description for known functions or configurations related to the disclosure may unnecessarily obscure the gist of the disclosure, the detailed description therefor will be abbreviated or omitted.

A display module according to the disclosure may be a micro light emitting diode (micro LED or µLED) display panel. The display module is a type of flat panel display panel, and includes a plurality of inorganic LEDs each having a size of 100 micrometers or less. The display module provides a contrast, a response time, and energy efficiency of higher quality than those of a liquid crystal display (LCD) panel requiring a backlight unit. Both of the organic LED (OLED) and the micro LED, which is an inorganic light emitting element, have excellent energy efficiency, but the micro LED has a higher brightness and luminous efficiency and a longer lifespan than those of the OLED. The micro LED may be a semiconductor chip that is capable of emitting light based on power supplied thereto. The micro LED has a fast reaction speed, low power, and high luminance. Specifically, the micro LED has a higher efficiency of converting electricity to photons than that of an existing liquid crystal display (LCD) or organic light emitting diode (OLED). That is, the micro LED has a higher "brightness per watt" than that of an existing LCD or OLED display. Therefore, the micro LED may achieve the same brightness as that of the existing LED (whose width, length, and height exceed 100 µm) or OLED with about a half of energy of the existing LED or OLED. In addition, the micro LED may implement a high resolution and an excellent color, contrast, and brightness, and may thus accurately express a wide range of colors and implement a clear screen even in the outdoors in which sunlight is bright. In addition, the micro LED is resistant to a burn-in phenomenon and generates a small amount of heat, such that a long lifespan of the micro LED is ensured without deformation of the micro LED.

In the disclosure, the micro LED may have a flip-chip structure in which an anode electrode and a cathode electrode are formed on the same first surface and a light emitting surface is formed on a second surface opposite to the first surface on which the electrodes are formed.

In the disclosure, a thin film transistor (TFT) layer, in which a TFT circuit is formed, may be disposed on a front surface of a glass substrate, and a power supply circuit that supplies power to the TFT circuit, a data driver, a gate driver, and a timing controller that controls each driver may be disposed on a rear surface of the glass substrate. A plurality of pixels arranged in the TFT layer may be driven by the TFT circuit.

In the disclosure, the front surface of the glass substrate may be divided into an active area and a dummy area. The active area may correspond to an area occupied by the TFT layer on the front surface of the glass substrate, and the dummy area may be an area other than the area occupied by the TFT layer on the front surface of the glass substrate.

In the disclosure, an edge area of the glass substrate may be the outermost area of the glass substrate. The edge area of the glass substrate may be a remaining area other than an area where a circuit is formed on the glass substrate. The edge area of the glass substrate may also include a portion of the front surface of the glass substrate that is adjacent to a side surface of the glass substrate and a portion of the rear surface of the glass substrate that is adjacent to the side surface of the glass substrate. The glass substrate may be a quadrangle type glass substrate. Specifically, the glass substrate may be a rectangular type or square type glass substrate. The edge area of the glass substrate may include at least one of four sides of the glass substrate.

In the disclosure, as a plurality of through wiring members formed in such a way as not to be exposed to a side surface of the TFT substrate are provided, the display module may achieve a bezel-less feature by minimizing the dummy area and maximizing the active area in the front surface of the TFT substrate, and a mounting density of the micro LEDs in the display module may be increased.

In the disclosure, a plurality of display modules that may achieve the bezel-less feature may be connected to provide a large multi-display device in which the active area is maximized. In this case, as the dummy area is minimized, each display module may be formed to maintain a pitch between pixels of adjacent display modules equal to a pitch between pixels in a single display module. Accordingly, it is possible to prevent a seam from appearing at a connection portion between the display modules.

In the disclosure, an example in which a plurality of through wiring members are formed at regular intervals in edge areas corresponding to two sides facing each other among edge areas corresponding to the four sides of the glass substrate is described. However, the disclosure is not limited thereto, and a plurality of through wiring members may also be formed at regular intervals in edge areas corresponding to two sides adjacent to each other. Further, in the disclosure, a plurality of through wiring members are formed at regular intervals only in an edge area corresponding to one side among edge regions corresponding to the four sides, but a plurality of through wiring members may also be formed at regular intervals in edge regions corresponding to three sides.

In the disclosure, the display module includes the glass substrate on which a plurality of LEDs are mounted and a side wiring is formed. A single display module may be installed in and applied to a wearable device, a portable device, a handheld device, and an electronic product or an electrical component requiring various displays, or a plurality of display modules may be assembled in a matrix form to be applied to a display device such as a monitor for a personal computer (PC), a high resolution television (TV), a signage (or digital signage), or an electronic display.

Hereinafter, a display module according to an embodiment of the disclosure will be described with reference to the drawings.

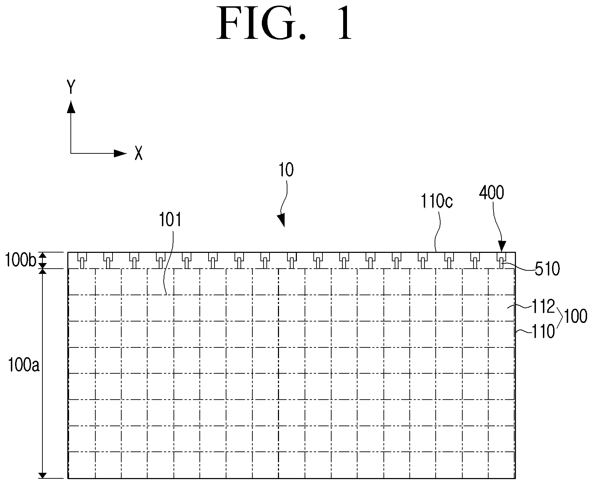

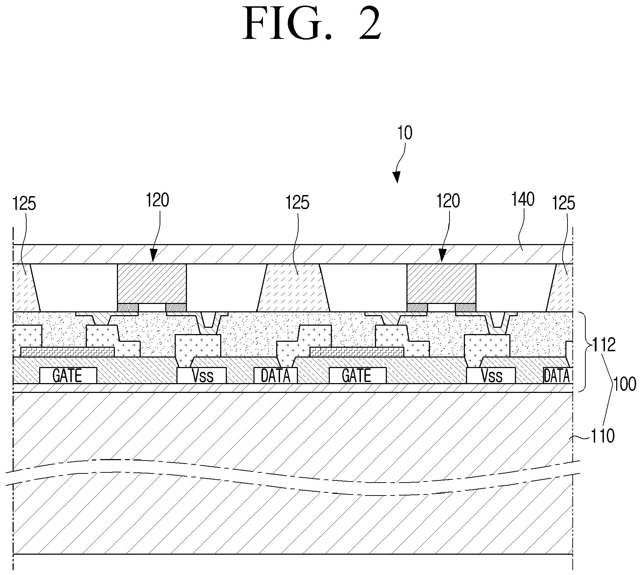

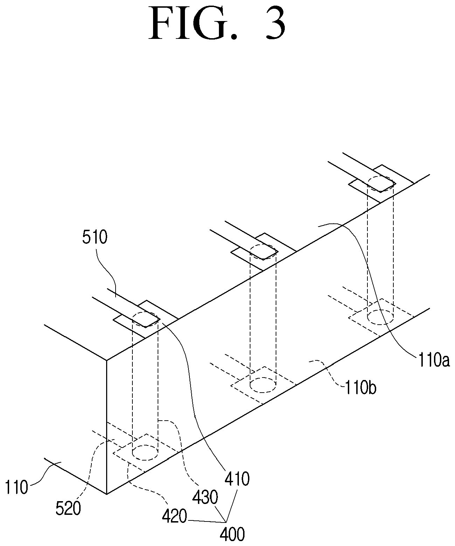

FIG. 1 is a plan view schematically illustrating the display module according to an embodiment of the disclosure, FIG. 2 is a cross-sectional view schematically illustrating the display module according to an embodiment of the disclosure, and FIG. 3 is a view illustrating an example in which a wiring is electrically connected to a through wiring member formed at an edge portion of a thin film transistor (TFT) substrate.

Referring to FIGS. 1 and 2, a display module 10 may include a TFT substrate 100 and a plurality of micro light emitting diodes (LEDs) 120 arranged on the TFT substrate 100.

The TFT substrate 100 may include a glass substrate 110, a TFT layer 112 including a TFT circuit on a front surface of the glass substrate 110, and a plurality of through wiring members 400 electrically connecting between a circuit (not illustrated) disposed on a rear surface of the glass substrate 110, supplying power to the TFT circuit, and electrically connected to a separate control substrate, and the TFT circuit of the TFT layer 112.

The TFT substrate 100 includes an active area 100a that displays an image and a dummy area 100b that may not display an image on its front surface.

The active area 100a may be divided into a plurality of pixel areas 101 in which a plurality of pixels are respectively arranged. The plurality of pixel areas 101 may be partitioned in various shapes, and may be partitioned in a matrix shape, for example. Each pixel area 101 may include a sub-pixel area in which a plurality of sub-pixels are mounted, and a pixel circuit area in which a pixel circuit for driving each sub-pixel is disposed. Here, the sub-pixel means one micro LED.

The plurality of micro LEDs 120 may be transferred to the pixel circuit area of the TFT layer 112, and electrode pads of each micro LED may be electrically connected to electrode pads formed in the sub-pixel area of the TFT layer 112, respectively. A common electrode pad may be formed in a straight shape in consideration of arrangement of at least two micro LEDs 120 positioned in each pixel area. The plurality of micro LEDs may be sub-pixels constituting a single pixel. In the disclosure, "one micro LED" means "one sub-pixel" and the terms may be used interchangeably.

A pixel driving method of the display module 10 according to an embodiment of the disclosure may be an active matrix (AM) driving method or a passive matrix (PM) driving method. In the display module 10, a pattern of a wiring to which each micro LED is electrically connected may be formed according to the AM driving method or the PM driving method.

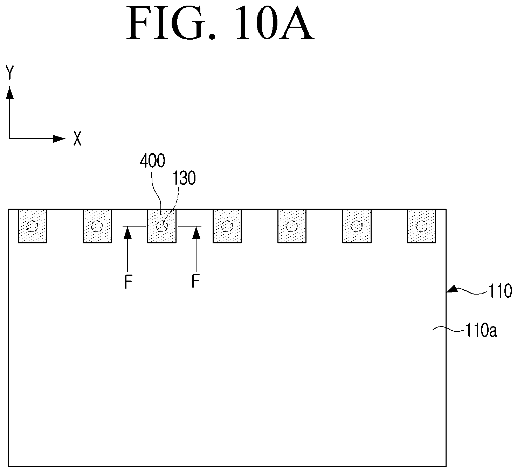

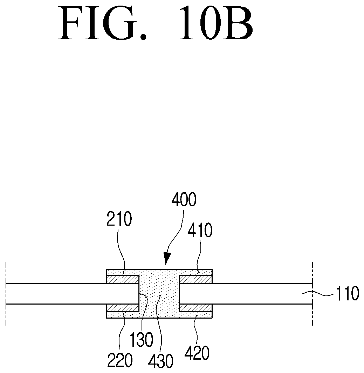

The dummy area 100b may be included in an edge area of the glass substrate 110. For example, in the disclosure, the edge area is an area in which the plurality of through wiring members 400 are formed, and may include a first area 110a (see FIG. 10) corresponding to a part of the front surface of the glass substrate 110 that is adjacent to a side surface 110c of the glass substrate 110, and a second area 110b (see FIG. 10) corresponding to a part of the rear surface of the glass substrate 110 that is adjacent to the side surface 100c of the glass substrate 110.

In FIG. 3, first and second conductive members 210 and 220 forming a part of the through wiring member 400 are not illustrated for convenience of explanation.

Referring to FIG. 3, the plurality of through wiring members 400 may include a plurality of first conductive members 210 formed in the first area 110a, a plurality of second conductive members 220 formed in the second area 110b, and a plurality of third conductive members each having a portion stacked on each of the first and second conductive members 210 and 220 and the other portion penetrating through the glass substrate 110. The plurality of first and second conductive members may be formed of copper (Cu) or a metal material having excellent conductivity.

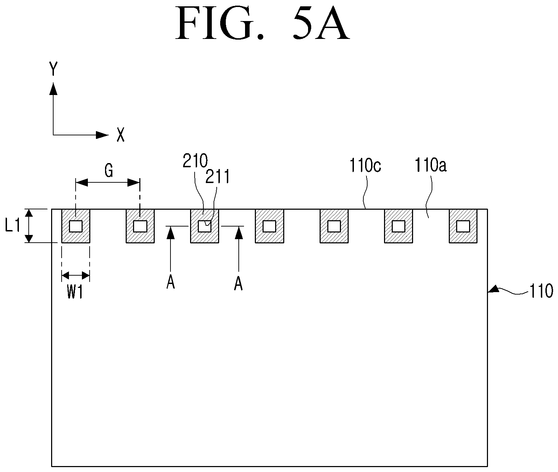

The plurality of first and second conductive members 210 and 220 may be arranged at regular intervals in the first and second areas 110a and 110b. Each of the first and second conductive members 210 and 220 may be formed to have a predetermined length L1 (see FIG. 5A) from a corner whose one side is in contact with the side surface 110c of the glass substrate 110 toward the active area 100a.

The third conductive member includes a first pad portion 410 stacked on the first conductive member 210, a second pad portion 420 stacked on the second conductive member 220, and a connection portion 430 penetrating through the front and rear surfaces of the glass substrate 110 and integrated with the first and second pad portions 410 and 420.

A plurality of first pad portions 410 may be electrically connected to the TFT circuit provided in the TFT layer 112 through a plurality of first wirings 510 formed on the front surface of the glass substrate 110, respectively.

The power supply circuit, the data driver, the gate driver, and the timing controller that controls each driver may be disposed on each of a plurality of second pad portions 420 through a plurality of second wirings 520 formed on the rear surface of the glass substrate 110, the power supply circuit, the data driver, the gate driver, and the timing controller being disposed on the rear surface of the glass substrate 110.

In this case, the power supply circuit, the data driver, the gate driver, and the timing controller may be mounted on a separately printed circuit board. The separately printed circuit board may be electrically connected to the plurality of second wirings 520 through a flexible printed circuit board (FPCB) or the like.

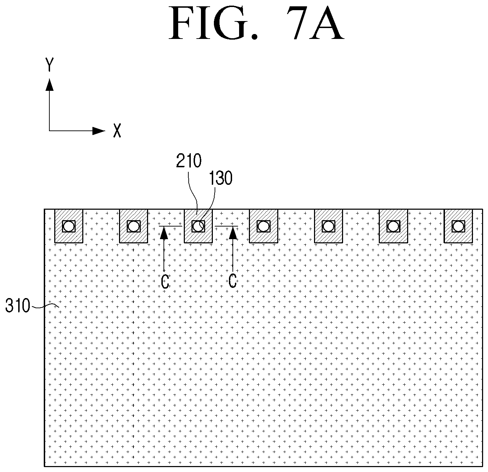

The plurality of connection portions 430 may be respectively formed in a plurality of through holes 130 (FIG. 7A) penetrating through the edge area of the glass substrate 110. In this case, the plurality of through holes 130 may be formed in such a way as to penetrate from the front surface to the rear surface of the glass substrate 110 (or to penetrate from the rear surface to the front surface of the glass substrate 110).

Each connection portion 430 may completely fill the through hole 130. However, each connection portion 430 need not be limited thereto and may be formed to have a predetermined thickness along an inner circumferential surface of the through hole 130 without completely filling the through hole 130. In this case, each connection portion 430 may be formed to have a predetermined cavity at the center.

The plurality of through wiring members 400 are formed along the edge area of the glass substrate 110 including the dummy area 100b. As described above, as the plurality of through wiring members 400 are disposed at the outermost portion of the glass substrate 110, the display module according to the disclosure may secure the active area 100a of the TFT substrate 100 as wide as possible.

The number of through wiring members 400 formed in the dummy area 100b may vary depending on the number of pixels and may vary depending on a driving method for the TFT circuit disposed in the active area 100a. For example, the active matrix (AM) driving method in which each pixel is separately driven may require more through wiring members 400 and first and second wirings 510 and 520 electrically connected to the through wiring members 400 as compared with the passive matrix (PM) driving method in which the TFT circuit disposed in the active area 100a drives a plurality of pixels in rows and columns.

According to the disclosure, the micro LED 120 may be a semiconductor chip that is formed of an inorganic light emitting material and is capable of emitting light by itself based on power supplied thereto. The micro LED 120 may have a predetermined thickness and may be formed in a square shape whose width and length are the same as each other, or a rectangle shape whose width and length are different from each other. Such a micro LED may implement real high dynamic range (HDR), improve luminance and black expression, and provide a higher contrast ratio as compared to the OLED. The size of the micro LED may be 100 µm or less, or may be 30 µm or less. The micro LED 120 may have a flip chip structure in which a pair of electrodes (for example, an anode electrode and a cathode electrode) is formed on the same surface and a light emitting surface is formed on a surface opposite to the surface on which the pair of electrodes is disposed.

Hereinafter, a method for manufacturing the display module according to an embodiment of the disclosure will be described.

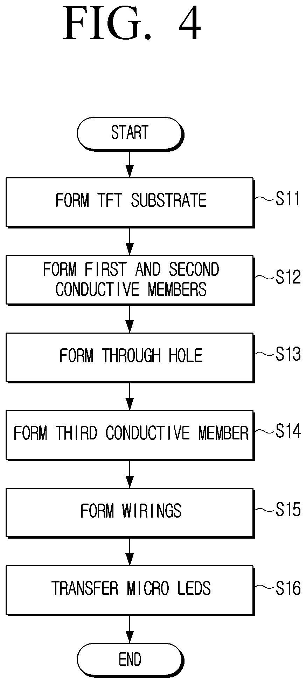

FIG. 4 is a flowchart illustrating a process of manufacturing the display module according to an embodiment of the disclosure.

First, the TFT substrate, in which the TFT layer 112 including the TFT circuit, is formed on the front surface of the glass substrate 110 is prepared (S11).

The power supply circuit, the data driver, the gate driver, and the timing controller that controls each driver may be mounted on the rear surface of the glass substrate 110.

Alternatively, the power supply circuit, the data driver, the gate driver, and the timing controller may be mounted on a separately printed circuit board (not illustrated). In this case, the separately printed circuit board may be electrically connected to the plurality of second wirings 520 through an FPCB (not illustrated).

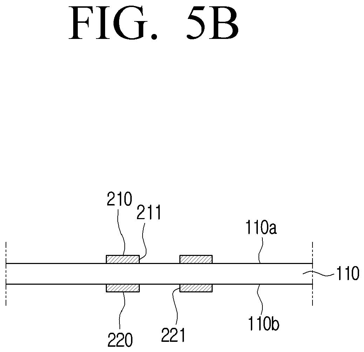

FIG. 5A is a view illustrating an example in which the first conductive member is formed on the edge portion of the TFT substrate, and FIG. 5B is a cross-sectional view taken along line A-A in FIG. 5A.

Referring to FIGS. 5A and 5B, the plurality of first and second conductive members 210 and 220 are formed in the edge area of the TFT substrate 100 (S12).

For example, the first conductive member 210 may be formed in the first area 110a corresponding to a portion of the front surface of the glass substrate 110, and the second conductive member 220 may be formed in the second area 110b corresponding to a portion of the rear surface of the glass substrate 110.

As an example, the plurality of first and second conductive members 210 and 220 may be formed by a sputtering process in which ionized inert gas collides with a target, and particles separated from the target due to the collision are attached to the glass substrate 110, thereby forming a thin film.

The plurality of first and second conductive members 210 and 220 may be formed on the glass substrate 110 by a deposition method using sputtering. In addition, the plurality of first and second conductive members 210 and 220 may also be formed by various wiring manufacturing methods such as a screen printing method, a stamping method, an inkjet method, and the like.

The plurality of first conductive members 210 formed in the first area 110a may be formed at regular intervals along the corner of the glass substrate 110. The plurality of second conductive members 220 formed in the second area 110b may be formed at regular intervals along other corners of the glass substrate 110.

In this case, the plurality of first and second conductive members 210 and 220 may be disposed to correspond to each other on a one-to-one basis. Accordingly, a distance between the first conductive members and a distance between the second conductive members may be the same or substantially similar with a difference within a margin of error.

The distance between the plurality of first conductive members 210 and the distance between the plurality of second conductive members 220 may become a distance between the plurality of finally formed through wiring members 400.

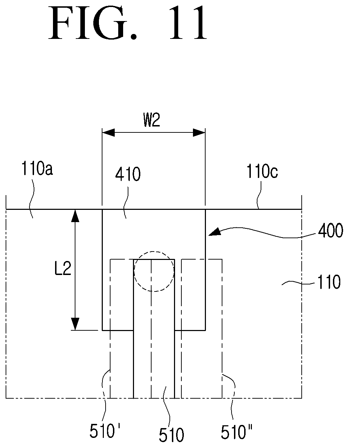

The plurality of first conductive members 210 may have a uniform width W1 and length L1. The width W1 of the plurality of first conductive members 210 may determine a width W2 (see FIG. 11) of the first pad portion 410 of the third conductive member formed in a subsequent process. The width and length of the plurality of second conductive members 220 and the width W1 and length L1 of the first conductive members 210 may be the same as each other or may be substantially similar to each other with a difference within a margin of error.

The width W1 of the plurality of first conductive members 210 may determine the width W2 (see FIG. 11) of the first pad portion 410 of the third conductive member formed in a subsequent process. Similarly, the width of the plurality of second conductive members 220 may determine a width of the second pad portion 420 of the third conductive member formed in a subsequent process.

The plurality of first and second conductive members 210 and 220 may be formed to have the predetermined length L1 from the corner whose one side is in contact with the side surface 110c of the glass substrate 110 toward the active area 100a (see FIG. 1).

Each of the plurality of first and second conductive members 210 and 220 may have a through area 211 or 221 corresponding to the through hole 130 (see FIG. 7A) formed at the center. The through areas 211 and 221 may be rectangular holes. Here, the through areas 211 and 221 do not need to be limited to the rectangular holes, and it is sufficient that the through areas 211 and 221 have a diameter equal to or greater than a diameter of the through hole 130 to be formed in the glass substrate 110.

The first conductive member 210 formed in the first area 110a may be formed at a position corresponding to the second conductive member 220 formed in the second area 110b.

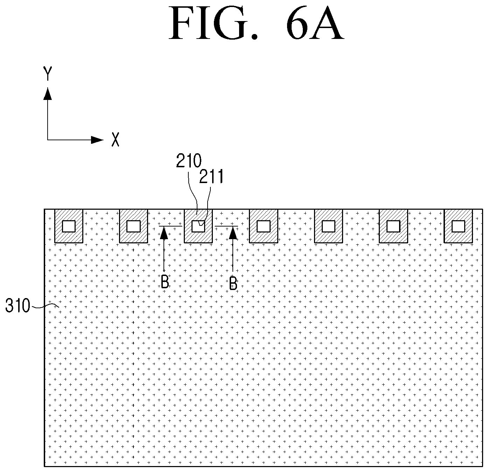

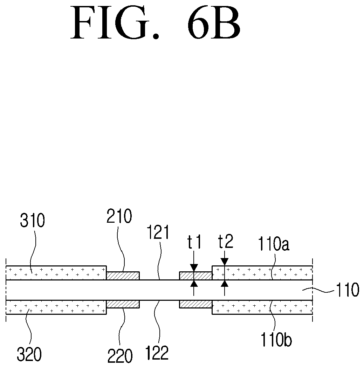

FIG. 6A is a diagram illustrating an example in which photoresist layers are formed in areas other than the areas where the first and second conductive members are formed, in the entire area of each of the front surface and the rear surface of the TFT substrate, and FIG. 6B is a cross-sectional view taken along line B-B in FIG. 6A.

Referring to FIGS. 6A and 6B, first and second photoresist layers 310 and 320 are formed on the front and rear surfaces of the TFT substrate by photolithography. In this case, the first and second photoresist layers 310 and 320 are formed in the remaining areas other than the areas where the plurality of first and second conductive members 210 and 220 are formed.

A thickness t2 of the first photoresist layer 310 may be larger than a thickness t1 of the first conductive member 210. A thickness of the second photoresist layer 320 and the thickness t2 of the first photoresist layer 310 may be the same as each other or substantially similar to each other with a difference within a margin of error. A thickness of the second conductive member 220 and the thickness t1 of the first conductive member 210 may be the same as each other or substantially similar to each other with a difference within a margin of error.

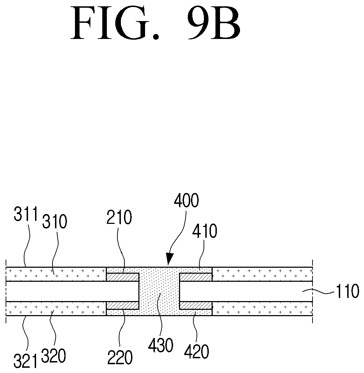

A difference (t1 < t2) in thickness between the first and second photoresist layers 310 and 320 and the first conductive members 210 and 220 may determine a thickness t3 (see FIG. 9B) of the first and second pad portions 410 and 420 of the third conductive member to be described later.

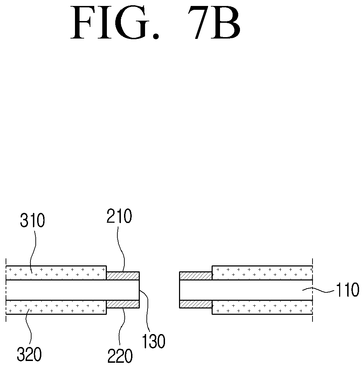

FIG. 7A is a view illustrating an example in which the through hole is formed in the TFT substrate, and FIG. 7B is a cross-sectional view taken along line C-C in FIG. 7A.

Referring to FIGS. 7A and 7B, the plurality of through holes 130 are formed in the edge area of the glass substrate 110 (S13).

Each through hole 130 may be formed from the through area 211 of each first conductive member 210 to the through area 221 of each second conductive member 220 corresponding thereto by, for example, laser processing.

In case that the through hole 130 is formed by laser processing, excellent processing quality may be achieved without being affected by the thickness (for example, 500 to 700 µm) of the glass substrate 110.

On the other hand, in case that the through hole 130 is formed by wet etching, micromachining is very difficult, and there is a risk of cracking as chipping occurs in the machined portion.

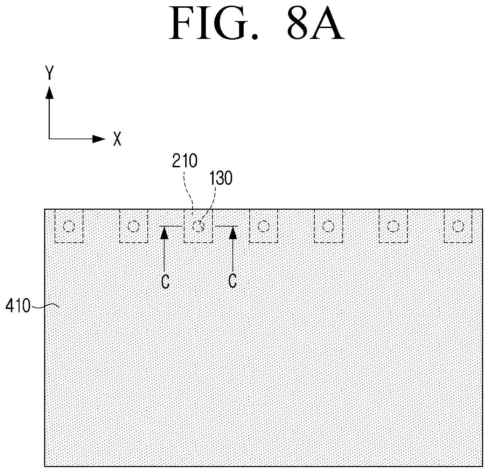

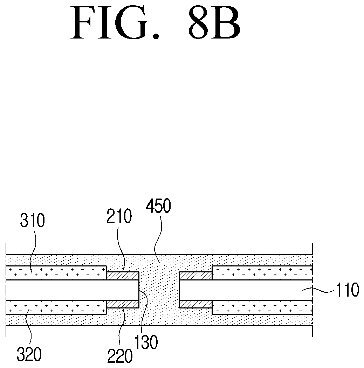

FIG. 8Ais a view illustrating an example in which the third conductive member is formed on the front and rear surfaces of the TFT substrate while filling the through hole formed in the TFT substrate, and FIG. 8B is a cross-sectional view taken along line D-D in FIG. 8A.

Referring to FIGS. 8A and 8B, a conductive layer 450 is stacked on the front and rear surfaces of the TFT substrate 100.

For example, the TFT substrate 100 is put into a container in which a conductive material (for example, copper (Cu) or a metal material having excellent conductivity) is stored to plate the entire area of the front and rear surfaces of the TFT substrate 100.

During plating, the conductive material flows onto the front and rear surfaces of the TFT substrate 100 and into the plurality of through holes 130 to fill each of the through holes 130. In this case, the conductive material flowing into each through hole 130 may closely adhere to the inner circumferential surface of the through hole 130 having a high surface uniformity due to laser processing.

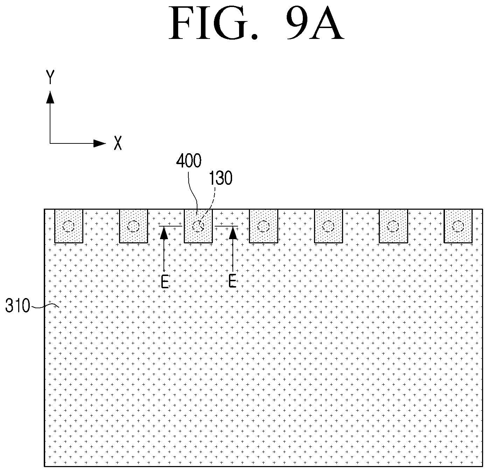

FIG. 9A is a view illustrating an example in which an upper portion of the third conductive member is polished up to an upper surface of the photoresist layer, and FIG. 9B is a cross-sectional view taken along line E-E in FIG. 9A.

Referring to FIGS. 9A and 9B, the third conductive member is formed by removing a portion of the conductive layer 450 formed on the front and rear surfaces of the TFT substrate 100 (S14).

For example, planarization may be made by polishing both surfaces (surfaces adjacent to the front and rear surfaces of the TFT substrate 100) of the conductive layer 450 formed on the front and rear surfaces of the TFT substrate 100 by a chemical-mechanical planarization (CMP) process.

In this case, the conductive layer 450 may be removed from the surface of the conductive layer 450 to a depth to which surfaces 311 and 321 of the first and second photoresist layers 310 and 320 may be exposed by the CMP process. The plurality of through wiring members 400 physically separated from each other may be formed by such a planarization process.

Further, a planarization depth may be a depth to which the surfaces 311 and 321 of the first and second photoresist layers 310 and 320 are partially removed. In this case, it may be preferable that the first and second pad portions 410 and 420 have a thickness sufficient to function properly.

FIG. 10A is a view illustrating an example in which the photoresist layers are removed from the front and rear surfaces of the TFT substrate, and FIG. 10B is a cross-sectional view taken along line F-F in FIG. 10A.

Referring to FIGS. 10A and 10B, the first and second photoresist layers 310 and 320 are removed from the front and rear surfaces of the TFT substrate 100 by a photoresist removal process.

In this case, each through wiring member 400 including the first to third conductive members are formed in the edge region of the TFT substrate 100 and thus may serve as a side wiring according to the related art.

In addition, in the through wiring member 400 according to the disclosure, the connection portion 430 of the through wiring member 400 is positioned inside the glass substrate 110 and is not exposed to the outside. Accordingly, in the disclosure, it is possible to fundamentally solve the problem of the side wiring according to the prior art, that is, disconnection caused by an external impact due to the exposure of the side wiring to the outside of the glass substrate, or disconnection due to an extremely small thickness of a portion of the side wiring that passes while covering the corner of the glass substrate.

In addition, a process of forming separate connection pads in the edge area of the glass substrate is required to electrically connect the side wiring according to the prior art to the first and second wirings formed on the front and rear surfaces of the glass substrate. On the other hand, in the through wiring member 400 according to the disclosure, the first and second pad portions 410 and 420 electrically connected to the first and second wirings 510 and 520 formed on the front and rear surfaces of the glass substrate 110 are integrally provided. Accordingly, the process for forming separate connection pads may be omitted.

As described above, after the plurality of through wiring members 400 are formed, the first and second wirings 510 and 520 electrically connected to the plurality of through wiring members 400 are formed as illustrated in FIG. 3 (S15).

The number of first wirings 510 is plural, and the first wirings 510 electrically connect the plurality of first pad portions 410 and the TFT circuit provided in the TFT layer 112. The number of second wirings 520 is plural, and the second wirings 520 electrically connect the plurality of second pad portions 420, and the power supply circuit, the data driver, and the gate driver disposed on the rear surface of the glass substrate 110.

Subsequently, the plurality of micro LEDs 120 may be transferred to the TFT layer 112 (S16).

The plurality of micro LEDs 120 may be transferred to the TFT substrate 100 by a transfer method such as a laser transfer method, an electrostatic head transfer method, or a rollable transfer method.

After the process of transferring the micro LEDs, a black matrix 125 may be formed between the micro LEDs as illustrated in FIG. 2 to prevent light emitted from adjacent micro LEDs from being mixed and prevent external light from being reflected on the TFT substrate 100.

In addition, a protective layer 140 covering the front surface of the TFT substrate 100 may be formed as illustrated in FIG. 2 in order to protect the TFT circuit and the plurality of micro LEDs 120 from an external impact. The protective layer 140 may be formed of a synthetic resin film or a glass material having a predetermined thickness.

FIG. 11 is a view illustrating an example of overcoming a position error of the wiring according to a length of the first pad portion of the through wiring member in an X direction.

The first pad portion 410 of the through wiring member 400 may have the predetermined width W2 for connection to the first wiring 510 even in case that the first wiring 510 is formed at a position outside a margin of error in manufacturing.

Referring to FIG. 11, in case that the first pad portion 410 is formed to have the predetermined width W2 in consideration of the margin of error in manufacturing the first wiring 510, electrical connection between the first pad portion 410 and the first wiring 510 may be maintained even in case that the first wiring 510 is biased to the left like a first wiring 510' or is biased to the right like a first wiring 510".

Further, the first pad portion 410 may be formed to have a predetermined length L2 from a corner adjacent to the side surface 110c of the glass substrate 110 toward the active area 100a (see FIG. 1). In this case, the length L2 of the first pad portion 410 may be an appropriate length in consideration of a distance at which connection to the first wiring 510 may be made.

The width and length of the second pad portion 420 and the width W2 and length L2 of the first pad portion 410 described above may be the same as each other or may be substantially similar to each other with a difference within a margin of error.

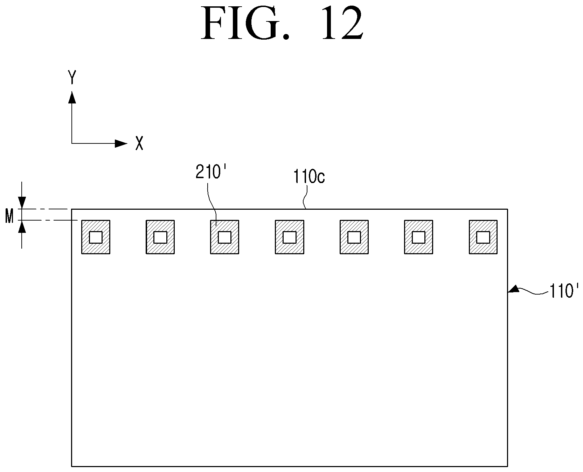

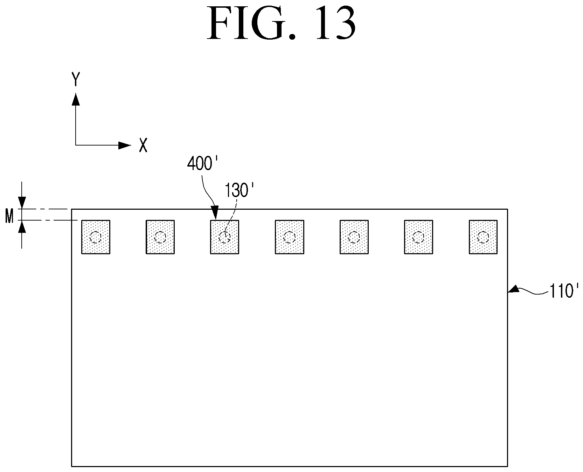

FIG. 12 is a view illustrating an example in which the first conductive member formed at the edge portion of the TFT substrate is spaced apart from one end of the TFT substrate by a predetermined distance M in a Y direction, and FIG. 13 is a view illustrating an example in which the through wiring member is formed using the TFT substrate illustrated in FIG. 12.

Referring to FIG. 12, arrangement of a plurality of first conductive members 210' on a glass substrate 110' is different from the arrangement of the plurality of first conductive members 210 (see FIG. 5A).

For example, the plurality of first conductive members 210' may be disposed at positions spaced apart from a corner that is adjacent to the side surface 110c of the glass substrate 110' by the predetermined distance M. In this case, similar to the first conductive members 210', the plurality of second conductive members formed on the rear surface of the glass substrate 110' may be disposed at positions spaced apart from a corner adjacent to the side surface 110c of the glass substrate 110' by the predetermined distance M.

In case of manufacturing the display module by using the TFT substrate in which the plurality of first conductive members 210' are formed, a plurality of through wiring members 400' may be disposed at positioned spaced apart from a corner adjacent to the side surface 110c of the glass substrate 110' by the predetermined distance M as illustrated in FIG. 13.

As such, according to the disclosure, it is possible to dispose the plurality of through wiring members 400 and 400' at appropriate positions in the dummy area 100b of the TFT substrate 100.

In addition, the formation position of the through hole 130 may correspond to the positions of the first and second conductive members 210 and 220, and may thus be determined according to the formation positions of the first and second conductive members 210 and 220.

Although various embodiments of the disclosure have been individually described hereinabove, the respective embodiments are not necessarily implemented singly, and may also be implemented so that configurations and operations thereof are combined with those of one or more other embodiments.

Although the embodiments of the disclosure have been illustrated and described hereinabove, the disclosure is not limited to the specific embodiments described above, but may be variously modified by those skilled in the art to which the disclosure pertains without departing from the scope and spirit of the disclosure claimed in the claims. These modifications should also be understood to fall within the scope of the disclosure.

### [INDUSTRIAL APPLICABILITY]

The disclosure relates to the display module and the method for manufacturing the same.

## Claims

1. A display module comprising:
a glass substrate;
a thin film transistor (TFT) layer formed on a front surface of the glass substrate and including a plurality of TFT electrodes;
a plurality of light emitting diodes electrically connected to the plurality of TFT electrodes; and
a plurality of through wiring members disposed at intervals along an edge area of the glass substrate and electrically connected to wirings formed on the front surface and a rear surface of the glass substrate, respectively,
wherein each of the plurality of through wiring members includes:
a first conductive member formed on the front surface of the glass substrate;
a second conductive member formed on the rear surface of the glass substrate; and
a third conductive member penetrating through the glass substrate and having both ends stacked on the first conductive member and the second conductive member, respectively.

2. The display module of claim 1, wherein the third conductive member includes:
a first pad portion stacked on the first conductive member and exposed to the outside;
a second pad portion stacked on the second conductive member and exposed to the outside; and
a connection portion electrically connected to the first pad portion and the second pad portion and disposed in a through hole of the glass substrate.

3. The display module of claim 2, wherein the first pad portion is electrically connected to a first wiring formed on the front surface of the glass substrate, and
the second pad portion is electrically connected to a second wiring formed on the rear surface of the glass substrate.

4. The display module of claim 2, wherein the first pad portion has one side in contact with a corner where the front surface and a side surface of the glass substrate meet each other, and
the second pad portion has one side in contact with a corner where the rear surface and the side surface of the glass substrate meet each other.

5. The display module of claim 2, wherein the first pad portion has one side spaced apart from a corner where the front surface and a side surface of the glass substrate meet each other, and
the second pad portion has one side spaced apart from a corner where the rear surface and the side surface of the glass substrate meet each other.

6. The display module of claim 2, wherein the first pad portion covers the entire first conductive member, and
the second pad portion covers the entire second conductive member.

7. The display module of claim 2, wherein a width of the first pad portion and a width of the second pad portion are larger than a width of a wiring connected to each of the first pad portion and the second pad portion.

8. A method for manufacturing a display module, the method comprising:
forming a plurality of first and second conductive members at regular intervals in an edge area of a glass substrate having a front surface on which a thin film transistor (TFT) layer is formed;
forming a plurality of through holes each penetrating through the glass substrate at positions corresponding to the plurality of first and second conductive members;
forming a third conductive member having one end stacked on the first conductive member to be electrically connected to the first conductive member and the other end stacked on the second conductive member to be electrically connected to the second conductive member through each through hole;
forming a first wiring electrically connected to one end of each third conductive member on the front surface of the glass substrate and a second wiring electrically connected to the other end of each third conductive member on a rear surface of the glass substrate; and
transferring a plurality of micro light emitting diodes (LEDs) to the TFT layer,
wherein one first conductive member, one second conductive member corresponding to the first conductive member, and one third conductive member electrically connected to the first conductive member and the second conductive member form one through wiring member.

9. The method of claim 8, further comprising, before the forming of the third conductive member, stacking a first photoresist layer to cover the front surface of the glass substrate including the TFT layer except for the plurality of first conductive members, and stacking a second photoresist layer to cover the rear surface of the glass substrate except for the plurality of second conductive members.

10. The method of claim 9, wherein the forming of the third conductive member comprises covering the plurality of first and second conductive members and the first and second photoresist layers with a conductive material.

11. The method of claim 10, wherein the conductive material is formed by a plating method in such a way that the conductive material is partially introduced into the plurality of through holes.

12. The method of claim 9, wherein the first photoresist layer is formed to have a thickness larger than that of the first conductive member, and
the second photoresist layer is formed to have a thickness larger than that of the second conductive member.

13. The method of claim 12, further comprising removing a part of a metal material until an upper surface of the first photoresist layer and an upper surface of the second photoresist layer covered with the metal material are exposed.

14. The method of claim 13, further comprising, after the removing of the part of the metal material, removing the first photoresist layer and the second photoresist layer.

15. The method of claim 13, wherein the part of the metal material is removed to a predetermined height by a planarization process.
